# EUROPÄISCHE PATENTANMELDUNG

(11) **EP 2 112 874 A2**
(43) Veröffentlichungstag der Anmeldung: **28.10.2009**
(21) Anmeldenummer: 09100241.0
(22) Anmeldetag: 21.04.2009
(51) Int. Cl.: H05K 7/20

(54) **Wärmeabfuhrsystem, elektronische Schaltung mit dem Wärmeabfuhrsystem und Verfahren zur Wärmeabfuhr**

(30) Priorität: 23.04.2008 DE 102008020328
(71) Anmelder: Continental Automotive GmbH, 30165 Hannover (DE)
(72) Erfinder: Brey, Roland, 93458 Eschlkam (DE)

(57) **Zusammenfassung**

Ein Wärmeabfuhrsystem, das zur Kühlung einer elektronischen Schaltung eingerichtet ist, umfasst ein Gehäuse (GH) mit einem geschlossenen Rohrsystem (RS), welches mit einem Arbeitsmedium gefüllt ist, eine im Gehäuse (GH) angeordnete Turbine (TU) und einen mit der Turbine (TU) mechanisch gekoppelten elektrischen Generator (GE). Das Rohrsystem (RS) weist ein Zuleitungsrohr (ZR), das einen Heizbereich (HB) des Gehäuses (GH) mit einem Zulauf der Turbine (TU) verbindet, und ein Rückleitungsrohr (RR) auf, das einen Ablauf der Turbine (TU) über einen Abkühlbereich (KB) des Gehäuses (GH) mit dem Heizbereich (HB) verbindet. Das Wärmeabfuhrsystem ist ferner dazu eingerichtet, das Arbeitsmedium in Abhängigkeit einer Wärmezufuhr aus der elektronischen Schaltung im Heizbereich (HB) zu erhitzen und in einen dampfförmigen Zustand zu bringen sowie das dampfförmige Arbeitsmedium der Turbine (TU) zu deren Antrieb zuzuführen.

## Beschreibung

Die Erfindung betrifft ein Wärmeabfuhrsystem zur Verwendung mit einer elektronischen Schaltung und eine elektronische Schaltung mit einem solchen Wärmeabfuhrsystem. Die Erfindung betrifft ferner ein Verfahren zur Wärmeabfuhr in einer elektronischen Schaltung.

Mit steigender Komplexität von elektronischen Schaltungen wird gleichzeitig immer mehr Verlustwärme beziehungsweise Verlustenergie mit höheren Temperaturen erzeugt. Da jedoch die Bauform der elektronischen Schaltungen beispielsweise in elektronischen Steuergeräten kompakter wird, ist die thermische Verlustenergie auf kleine Bereiche konzentriert. Dies kann zu Problemen in der Zuverlässigkeit und bei der Lebensdauer der Schaltungen führen. Beispielsweise sinkt die Lebensdauer eines Steuergeräts mit einer elektronischen Schaltung mit steigender Umgebungstemperatur beziehungsweise Betriebstemperatur. Zusätzlich kann durch die Verlustwärme auch die zulässige Höchsttemperatur für einzelne Komponenten der Schaltung überschritten werden, was zum Ausfall dieser Komponenten beziehungsweise zum Ausfall der gesamten elektronischen Schaltung führen kann.

Bei herkömmlichen Schaltungen wird beispielsweise regelmäßig eine aktive oder eine passive Kühlung zur Abfuhr der Verlustwärme vorgesehen. Als passive Kühlung werden beispielsweise Kühlkörper wie Kühlrippen eingesetzt, während für eine aktive Kühlung Lüfter oder Kreisläufe mit Kühlflüssigkeit eingesetzt werden. Durch diese Maßnahmen wird zwar die Verlustwärme an die Umgebung abgeführt, um die Temperatur der Schaltung in einem zulässigen Bereich zu halten, jedoch führt die abgeführte thermische Energie zu einer Verschlechterung des Wirkungsgrades der elektronischen Schaltung.

Es ist Aufgabe der Erfindung, ein Wärmeabfuhrsystem und ein Verfahren zur Wärmeabfuhr in einer elektronischen Schaltung bereit zu stellen, mit denen eine zuverlässige Kühlung und eine Erhöhung des Wirkungsgrades der elektronischen Schaltung erreicht wird. Es ist ferner Aufgabe der Erfindung, eine elektronische Schaltung mit einem solchen Wärmeabfuhrsystem anzugeben.

Diese Aufgabe wird mit den Gegenständen der unabhängigen Patentansprüche gelöst. Vorteilhafte Ausführungsformen und Weiterbildungen sind Gegenstand der Unteransprüche und gehen aus der nachfolgenden Beschreibung und den Zeichnungen hervor.

In einem Ausführungsbeispiel eines Wärmeabfuhrsystems, das zur Kühlung einer elektronischen Schaltung eingerichtet ist, umfasst dieses ein Gehäuse mit einem geschlossenen Rohrsystem, das mit einem Arbeitsmedium gefüllt ist, eine im Gehäuse angeordnete Turbine und einen mit der Turbine mechanisch gekoppelten elektrischen Generator. Das Rohrsystem weist ein Zuleitungsrohr auf, das einen Heizbereich des Gehäuses mit einem Zulauf der Turbine verbindet, sowie ein Rückleitungsrohr, das einen Ablauf der Turbine über einen Abkühlbereich des Gehäuses mit dem Heizbereich verbindet. Das Wärmeabfuhrsystem ist hierbei dazu eingerichtet, das Arbeitsmedium in Abhängigkeit einer Wärmezufuhr aus der elektronischen Schaltung im Heizbereich zu erhitzen und in einem dampfförmigen Zustand zu bringen sowie das dampfförmige Arbeitsmedium der Turbine zu deren Antrieb zuzuführen.

Im Betrieb des Wärmeabfuhrsystems wird dieses derart an eine Wärmequelle in einer elektronischen Schaltung angebracht, dass Wärme beziehungsweise thermische Energie von der Wärmequelle an den Heizbereich des Wärmeabfuhrsystems zugeführt wird. Das Arbeitsmedium, das beispielsweise Wasser, Alkohol, ein Alkohol-Wasser-Gemisch oder ein anderes flüssiges Wärmetransportmittel umfassen kann, wird durch die Wärmezufuhr von einem flüssigen in einen gasförmigen beziehungsweise dampfförmigen Zustand überführt. Durch das Verdampfen der Flüssigkeit wird in dem Zuleitungsrohr eine Strömung erzeugt, die das dampfförmige Arbeitsmedium zur Turbine führt, die durch das strömende Arbeitsmedium angetrieben wird. Die Rotationsenergie der Turbine wird durch den angekoppelten Generator in elektrische Energie umgewandelt. Durch die Strömung des Arbeitsmediums wird dieses nach der Turbine im Rückleitungsrohr zunächst durch den Abkühlbereich geführt, in dem es wieder möglichst vollständig verflüssigt wird. Schließlich wird das flüssige Arbeitsmedium über das Rückleitungsrohr in den Heizbereich geleitet, wo es erneut erhitzt werden kann.

Die elektrische Energie, die von dem Generator durch den Antrieb der Turbine erzeugt wird, kann von der elektronischen Schaltung zu deren Versorgung verwendet werden. Dadurch lässt sich die von außen an die elektronische Schaltung zuzuführende Energie reduzieren, was den Wirkungsgrad der elektronischen Schaltung verbessert. Durch die Abfuhr der Abwärme aus der elektronischen Schaltung wird zudem die Betriebstemperatur reduziert, was die Zuverlässigkeit der Schaltung erhöht.

Da das Rohrsystem mit dem Arbeitsmedium einen geschlossenen Kreislauf darstellt, kann eine Wartung des Wärmeabfuhrsystems entfallen. In Abhängigkeit einer zu erwartenden Kühlleistung kann das Wärmeabfuhrsystem in kompakter Form hergestellt werden, so dass es ähnlich einem Bauelement in der elektronischen Schaltung verbaut werden kann.

Zur Unterstützung der Kühlung des Arbeitsmediums im Abkühlbereich weist dieser vorzugsweise Kühlrippen auf. Beispielsweise sind im Abkühlbereich Kühlrippen am Gehäuse befestigt beziehungsweise durch entsprechende Formung des Gehäuses gebildet.

Beispielsweise kann das Gehäuse aus Aluminium hergestellt werden. Hierbei können die Rohrleitungen des Rohrsystems in einen Aluminiumkörper eingefräst sein, der das Gehäuse des Wärmeabfuhrsystems bildet. Auch die Turbine kann aus Aluminium gefertigt werden. Alternativ können das Gehäuse und das Rohrleitungssystem auch aus keramischen Werkstoffen hergestellt werden. Alternativ kann das Gehäuse mit dem Rohrsystem auch mit einem Druckgussverfahren aus Aluminium hergestellt werden.

Der Generator ist vorzugsweise zur Erzeugung von Gleichstrom eingerichtet. Da eine Spannungsversorgung von elektronischen Schaltungen üblicherweise bevorzugt mit Gleichspannungsquellen erfolgt, kann somit die vom Generator erzeugte elektrische Energie ohne aufwändige Transformation in der Schaltung verwendet werden. Es können jedoch Pufferelemente wie z. B. Kondensatoren vorgesehen werden, in denen die vom Generator erzeugte elektrische Energie zwischengespeichert wird, so dass eine gleichmäßigere Entnahme der Energie durch die elektronische Schaltung möglich wird.

Der Generator kann sowohl zusammen mit der Turbine im Gehäuse angeordnet sein als auch an der Außenseite des Gehäuses befestigt werden. Im letzteren Fall ist beispielsweise eine mit der Turbine verbundene Antriebswelle aus dem Gehäuse herausgeführt, über die die Rotationsenergie der Turbine auf den Generator übertragen werden kann. Beispielsweise ist der Generator direkt auf die Welle aufgesetzt. Alternativ könnte ein Antrieb des Generators auch über ein zwischengeschaltetes Getriebe erfolgen.

In einer Ausführungsform des Wärmeabfuhrsystems ist ein Durchmesser des Zuleitungsrohres größer als ein Durchmesser des Rückleitungsrohres. Da das Arbeitsmedium im dampfförmigen Zustand ein größeres Volumen einnimmt als im flüssigen Zustand, kann es vorteilhaft sein, den Durchmesser des Zuleitungsrohres und des Rückleitungsrohres an die unterschiedlichen Aggregatszustände des Arbeitsmediums anzupassen.

Ein Ausführungsbeispiel einer elektronischen Schaltung weist ein Wärmeabfuhrsystem nach einem der beschriebenen Ausführungsbeispiele auf. Das Wärmeabfuhrsystem ist dabei dazu eingerichtet, Abwärme aus der elektronischen Schaltung abzuführen, während die elektronische Schaltung eingerichtet ist, die von dem Wärmeabfuhrsystem erzeugte elektrische Energie zu verwenden.

In einem Ausführungsbeispiel eines Verfahrens zur Wärmeabfuhr in einer elektronischen Schaltung wird ein Arbeitsmedium mit einer Wärmequelle in der elektronischen Schaltung aus einem flüssigen Zustand in einen dampfförmigen Zustand überführt. Das dampfförmige Arbeitsmedium wird über ein Zuleitungsrohr an eine Turbine zu deren Antrieb zugeführt. Mittels der Turbine wird zudem ein elektrischer Generator angetrieben. Das Arbeitsmedium wird abgekühlt und über ein Rückleitungsrohr zur der Wärmequelle zurückgeführt, wobei das Arbeitsmedium beim Abkühlen in den flüssigen Zustand überführt wird.

Die elektrische Energie, die von dem Generator erzeugt wird, kann in der elektronischen Schaltung verwendet werden. Dadurch wird der Wirkungsgrad der Schaltung verbessert.

Die Erfindung wird nachfolgend an mehreren Ausführungsbeispielen anhand der Figuren näher erläutert. Funktions- beziehungsweise wirkungsgleiche Elemente tragen gleiche Bezugszeichen. Soweit sich Elemente in ihrer Funktion entsprechen, wird deren Beschreibung nicht in jeder der folgenden Figuren wiederholt. Die dargestellten Elemente und deren Größenverhältnisse untereinander sind grundsätzlich nicht als maßstabsgerecht anzusehen, vielmehr können einzelne Elemente zur besseren Darstellbarkeit und/oder zum besseren Verständnis übertrieben groß dargestellt sein.

Es zeigen:
- Figur 1: ein erstes Ausführungsbeispiel eines Wärmeabfuhr- systems,
- Figur 2: ein zweites Ausführungsbeispiel eines Wärmeabfuhr- systems, und
- Figur 3: ein drittes Ausführungsbeispiel eines Wärmeabfuhr- systems.

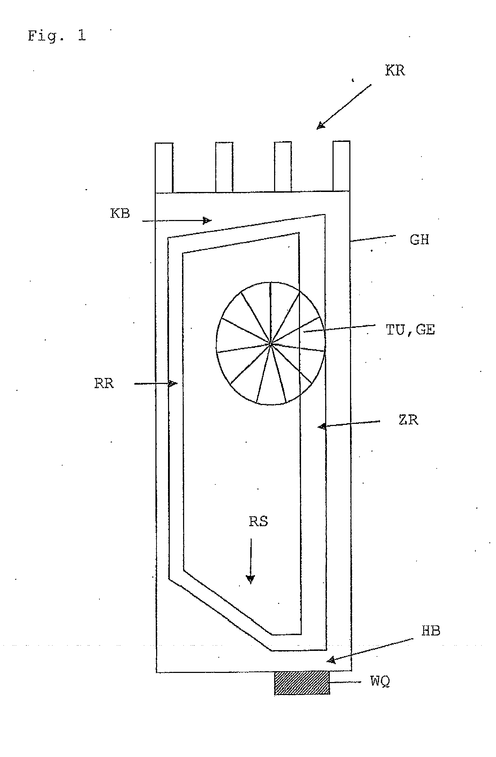

In Figur 1 ist ein Ausführungsbeispiel eines Wärmeabfuhrsystems mit einem Gehäuse GH dargestellt. In dem Gehäuse GH ist ein Rohrleitungssystem RS vorgesehen, das mit einem hier aus Übersichtsgründen nicht dargestellten Arbeitsmedium gefüllt ist. Ferner weist das Gehäuse GH eine schematisch dargestellte Turbine TU auf, die mit einem hier nicht sichtbaren elektrischen Generator mechanisch gekoppelt ist. Das Rohrsystem RS weist ein Zuleitungsrohr ZR auf, das eine vertikale Verbindung von einem Heizbereich HB zu einem Zulauf der Turbine TU darstellt. Das Rohrsystem RS umfasst ferner ein Rückleitungsrohr RR, das einen Ablauf der Turbine TU zunächst nach oben über einen Kühlbereich KB und schließlich nach unten zurück zum Heizbereich HB führt. Der Kühlbereich KB weist zudem Kühlrippen KR auf, die an der Oberseite des Gehäuses GH angeordnet sind. Der Durchmesser des Zuleitungsrohrs ZR ist in diesem Ausführungsbeispiel größer als der Durchmesser des Rückleitungsrohres RR. Das Rohrleitungssystem RS bildet mit dem Zuleitungsrohr ZR und dem Rückleitungsrohr RR einen geschlossenen Kreislauf.

Der Heizbereich HB des Gehäuses GH ist in der Darstellung mit einer Wärmequelle WQ verbunden, die beispielsweise durch ein elektronisches Bauelement einer elektronischen Schaltung gebildet ist, welches im Betrieb eine hohe Wärmeentwicklung aufweist.

Das Arbeitsmedium, mit dem das Rohrleitungssystem RS gefüllt ist, kann beispielsweise Wasser, Alkohol, oder ein Gemisch daraus umfassen. Vorzugsweise wird als Arbeitsmedium eine Flüssigkeit gewählt, die auch bei niedrigen Betriebstemperaturen der Anordnung einen flüssigen, jedoch keinen festen Aggregatszustand einnimmt.

Im Betrieb des Wärmeabfuhrsystems und der mit dem System verbundenen Wärmequelle WQ wird von der Wärmequelle WQ thermische Energie in den Heizbereich HB des Systems abgegeben. Dadurch wird das Arbeitsmedium im Rohrleitungssystem RS, das im Heizbereich einen flüssigen Zustand einnimmt, erhitzt und in einen dampfförmigen Zustand überführt. Das dampfförmige Arbeitsmedium steigt in dem vertikal angeordneten Zuleitungsrohr wegen der Erhitzung an und wird dampfförmig in die Turbine TU gedrückt. Durch Ausnutzung der Totalentalpie des Arbeitsmediums wird die Energie des strömenden, dampfförmigen Arbeitsmediums in Rotationsenergie der Turbine TU und des damit verbundenen Generators GE umgewandelt. Da dem Arbeitsmedium somit Energie entzogen wird, beginnt es abzukühlen, wobei eine umfassendere Abkühlung des Arbeitsmediums im Kühlbereich KB erfolgt. Dabei wird das Arbeitsmedium auch vom dampfförmigen Zustand in den flüssigen Zustand überführt. Das so abgekühlte und wieder flüssig gewordene Arbeitsmedium läuft über den vertikalen Teil des Rückleitungsrohrs RR zurück zum Heizbereich HB, wo es erneut erhitzt werden kann.

Die elektrische Energie, die vom Generator GE aus der Rotationsenergie gewonnen wird, wird in Form von Strom und Spannung beispielsweise an die hier nicht dargestellte elektronische Schaltung abgegeben, in der z. B. auch die Wärmequelle WQ angeordnet ist. Der Energiebedarf der elektronischen Schaltung aus einer externen Energiequelle kann somit reduziert werden. Dadurch steigt der Wirkungsgrad der elektronischen Schaltung.

Die elektronische Schaltung kann beispielsweise von einem Steuergerät umfasst sein. Ein Steuergerät kann z. B. als Motorsteuerung ausgeführt sein, die im Motorbereich eines Fahrzeugs angeordnet ist. Hierbei werden die Temperaturen in dem Steuergerät nicht nur durch Abwärme der elektronischen Schaltung selbst, sondern auch durch Abwärme vom Motor beeinflusst. Durch das dargestellte Wärmeabfuhrsystem kann jedoch Wärme derart aus dem Steuergerät abgeführt werden, dass die Temperatur während des Betriebs einen zulässigen Bereich einhält.

Ein alternatives Anwendungsbeispiel, bei dem das dargestellte Wärmeabfuhrsystem in einem Steuergerät eingesetzt werden kann ist ein Steuergerät, das an einem Auspuff beziehungsweise einem Katalysator eines Fahrzeugs angebracht ist. Auch in diesem Fall wird die Betriebstemperatur des Steuergeräts nicht nur von thermischen Verlusten der elektronischen Schaltung, sondern auch durch die Temperatur des Auspuffs beziehungsweise des Katalysators bestimmt.

Anders ausgedrückt kann durch das beschriebene Wärmeabfuhrsystem sowohl thermische Energie, die von der elektronischen Schaltung selbst produziert wird, als auch thermische Energie, die der Umgebung entnommen wird, in elektrische Energie umgewandelt werden, die sich in der Schaltung verwenden lässt.

Bei herkömmlichen Steuergeräten werden zur Kühlung der verwendeten elektronischen Schaltungen vielfach passive Kühlmaßnahmen wie Kühlrippen eingesetzt, deren Volumen die Bauform des Steuergeräts vergrößert und damit deren Herstellung verteuert. Alternativ werden bei herkömmlichen Steuergeräten auch Bauelemente eingesetzt, die unempfindlicher gegen hohe Temperaturen sind. Derartige Bauelemente sind jedoch regelmäßig teurer als gewöhnliche Bauelemente, so dass auch in diesem Fall die Kosten des Steuergeräts erhöht sind. Durch die Verwendung des dargestellten Wärmeabfuhrsystems können die Bauformen des Steuergeräts verkleinert und auf teurere, unempfindlichere Bauelemente verzichtet werden.

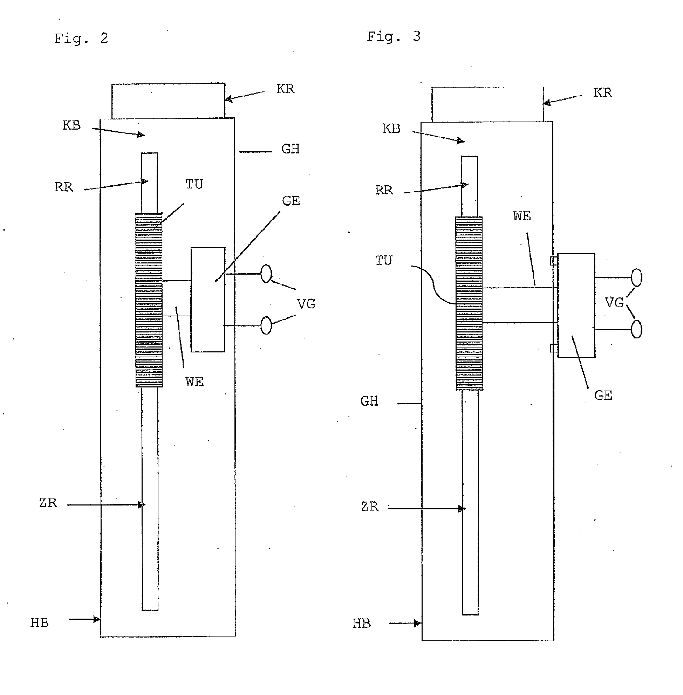

Figur 2 zeigt ein weiteres Ausführungsbeispiel eines Wärmeabfuhrsystems, bei dem im Vergleich zu Figur 1 eine Seitenansicht gewählt ist. Die Funktionsweise des Systems entspricht bezüglich des Rohrsystems RS mit Zuleitungsrohr ZR und Rückleitungsrohr RR zum Antrieb der Turbine TU der in Figur 1 dargestellten Ausführungsform.

In dem Ausführungsbeispiel in Figur 2 ist der Generator GE über eine Welle WE mit der Turbine TU mechanisch gekoppelt, wobei der Generator innerhalb des Gehäuses GH angeordnet ist. Aus dem Gehäuse GH sind lediglich elektrische Anschlüsse VG zum Abgreifen einer vom Generator GE erzeugten Spannung herausgeführt. Vorzugsweise ist der Generator GE als Gleichstrom- beziehungsweise Gleichspannungsgenerator ausgeführt, so dass die erzeugte Spannung in einfacher Weise zur Versorgung einer elektronischen Schaltung verwendet werden kann.

Figur 3 zeigt ein alternatives Ausführungsbeispiel des Wärmeabfuhrsystems, das sich von dem in Figur 2 dargestellten System im Wesentlichen dadurch unterscheidet, dass der Generator GE außerhalb des Gehäuses GH angeordnet und an diesem befestigt ist. Eine mechanische Kopplung des Generators GE mit der Turbine TU erfolgt wiederum über die Welle WE.

Durch die Kombination von Wärmetransport und Stromerzeugung in dem Wärmeabfuhrsystem kann eine elektronische Schaltung sowohl gezielt gekühlt werden als auch kann Energie aus Abwärme zurückgewonnen werden. Durch den geschlossenen Kreislauf des Rohrleitungssystems RS ist ein wartungsfreier Anbau auch bei schwer zugänglichen Stellen möglich. Da das Wärmeabfuhrsystem in einer der gezeigten Ausführungsform als ein Element einer Schaltung beziehungsweise eines Steuergeräts verbaut werden kann, verursacht es geringe Montagekosten.

## Patentansprüche

1. Wärmeabfuhrsystem, eingerichtet zur Kühlung einer elektronischen Schaltung, umfassend
- ein Gehäuse (GH) mit einem geschlossenen Rohrsystem (RS), das mit einem Arbeitsmedium gefüllt ist;
- eine im Gehäuse (GH) angeordnete Turbine (TU); und
- einen mit der Turbine (TU) mechanisch gekoppelten elektrischen Generator (GE);
- das Rohrsystem (RS) aufweisend ein Zuleitungsrohr (ZR), das einen Heizbereich (HB) des Gehäuses (GH) mit einem Zulauf der Turbine (TU) verbindet, und ein Rückleitungsrohr (RR), das einen Ablauf der Turbine (TU) über einen Abkühlbereich (KB) des Gehäuses (GH) mit dem Heizbereich (HB) verbindet; wobei
- das Wärmeabfuhrsystem dazu eingerichtet ist, das Arbeitsmedium in Abhängigkeit einer Wärmezufuhr aus der elektronischen Schaltung im Heizbereich (HB) zu erhitzen und in einen dampfförmigen Zustand zu bringen sowie das dampfförmige Arbeitsmedium der Turbine (TU) zu deren Antrieb zuzuführen.

2. Wärmeabfuhrsystem nach Anspruch 1,
bei dem der Abkühlbereich (KB) Kühlrippen (KR) aufweist.

3. Wärmeabfuhrsystem nach Anspruch 1 oder 2,
bei dem das Arbeitsmedium Wasser und/oder Alkohol umfasst.

4. Wärmeabfuhrsystem nach einem der Ansprüche 1 bis 3,
bei dem das Gehäuse (GH) Aluminium umfasst.

5. Wärmeabfuhrsystem nach einem der Ansprüche 1 bis 4,
bei dem der Generator (GE) im Gehäuse (GH) angeordnet ist.

6. Wärmeabfuhrsystem nach einem der Ansprüche 1 bis 4,
bei dem der Generator (GE) an der Außenseite des Gehäuses (GH) befestigt ist.

7. Wärmeabfuhrsystem nach einem der Ansprüche 1 bis 6,
bei dem ein Durchmesser des Zuleitungsrohrs (ZR) größer als ein Durchmesser des Rückleitungsrohrs (RR) ist.

8. Wärmeabfuhrsystem nach einem der Ansprüche 1 bis 7,
bei dem der Generator (GE) zur Erzeugung von Gleichstrom eingerichtet ist.

9. Elektronische Schaltung mit einem Wärmeabfuhrsystem nach einem der Ansprüche 1 bis 8, bei der das Wärmeabfuhrsystem dazu eingerichtet ist, Abwärme aus der elektronischen Schaltung abzuführen und die eingerichtet ist, von dem Wärmeabfuhrsystem erzeugte elektrische Energie zu verwenden.

10. Verfahren zur Wärmeabfuhr in einer elektronischen Schaltung, umfassend
- Überführen eines Arbeitsmediums mit einer Wärmequelle (WQ) in der elektronischen Schaltung aus einem flüssigen Zustand in einen dampfförmigen Zustand;
- Zuführen des dampfförmigen Arbeitsmediums über ein Zuleitungsrohr (ZR) an eine Turbine (TU) zu deren Antrieb;
- Antreiben eines elektrischen Generators (GE) mittels der Turbine (TU); und
- Abkühlen und Rückführen des Arbeitsmediums über ein Rückleitungsrohr (RR) zu der Wärmequelle (WQ), wobei das Arbeitsmedium beim Abkühlen in den flüssigen Zustand überführt wird.
